# EUROPEAN PATENT APPLICATION

(11) **EP 4 814 162 A1**
(43) Date of publication of application: **30.09.2026**
(21) Application number: 26168202.5
(22) Date of filing: 26.03.2026
(51) Int. Cl.: C23C 16/455, C23C 16/04, C23C 16/34

(54) **SUBSTRATE PROCESSING METHOD, METHOD OF MANUFACTURING SEMICONDUCTOR DEVICE, SUBSTRATE PROCESSING APPARATUS AND PROGRAM**

(30) Priority: 28.03.2025 JP 2025057225
(71) Applicant: Kokusai Electric Corp., Tokyo 100-0004 (JP)
(72) Inventor: JODA, Takuya, Toyama-shi, Toyama 939-2393 (JP); MINETA, Riku, Toyama-shi, Toyama 939-2393 (JP)
(74) Representative: Verscht, Thomas Kurt Albert

(57) **Abstract**

It is possible to improve characteristics of a film formed on a substrate. There is provided a technique that includes: (a) supplying a source gas; (b) supplying a first adsorption promoter; (c) supplying a reactive gas; (d) forming a film on a substrate by sequentially performing (a), (b) and (c) a predetermined number of times; and (e) supplying a first adsorption inhibitor in (d), wherein (e) is performed before (b) or after (b), or (e) is performed before (b) and after (b).

## Description

### [Technical Field]

The present disclosure relates to a substrate processing method, a method of manufacturing a semiconductor device, a substrate processing apparatus and a program.

### [Related Art]

As a part of a substrate processing (that is, a manufacturing process of a semiconductor device), a film may be formed on a substrate by supplying a source gas containing a halogen element and a reactive gas to the substrate (see, for example, Patent Document 1).

### [Related Art Document]

### [Patent document]

Patent Document 1: International Patent Publication No. WO2019/058608.

### [Disclosure]

### [Technical Problem]

According to the present disclosure, there is provided a technique capable of improving characteristics of a film formed on a substrate.

### [Technical Solution]

According to an embodiment of the present disclosure, there is provided a technique that includes: (a) supplying a source gas; (b) supplying a first adsorption promoter; (c) supplying a reactive gas; (d) forming a film on a substrate by sequentially performing (a), (b) and (c) a predetermined number of times; and (e) supplying a first adsorption inhibitor in (d), wherein (e) is performed before (b) or after (b), or (e) is performed before (b) and after (b).

### [Advantageous Effects]

According to some embodiments of the present disclosure, it is possible to improve characteristics of a film formed on a substrate.

### [Brief Description of Drawings]

FIG. 1 is a diagram schematically illustrating a vertical cross-section of a substrate processing apparatus according to one or more embodiments of the present disclosure.
FIG. 2 is a block diagram schematically illustrating a configuration of a controller and its related components of the substrate processing apparatus.
FIG. 3 is a flow chart schematically illustrating a substrate processing according to the embodiments of the present disclosure.

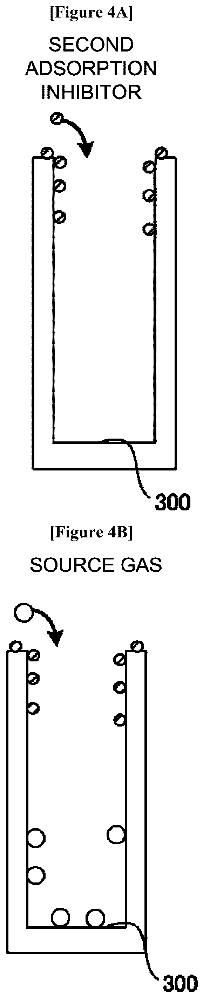

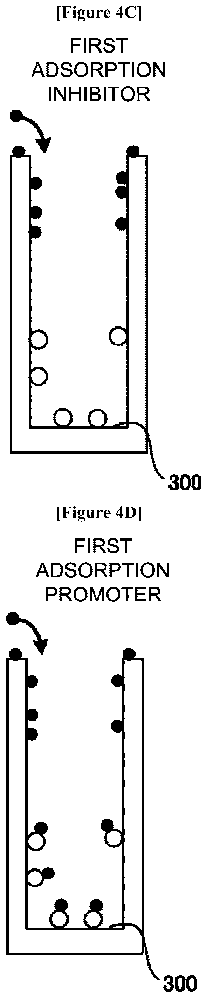

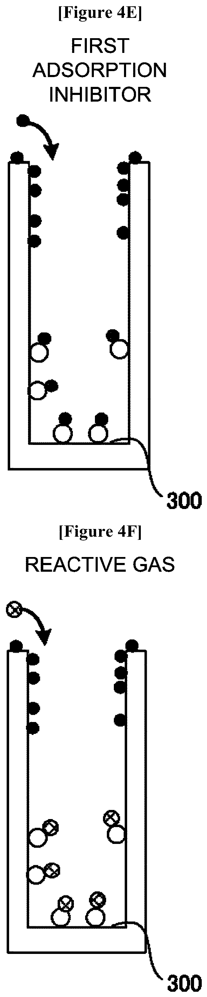

FIG. 4A is a diagram schematically illustrating adsorption locations of a second adsorption inhibitor in a recess (that is, a concave portion) of a substrate, FIG. 4B is a diagram schematically illustrating adsorption locations of a source gas in the recess of the substrate, FIG. 4C is a diagram schematically illustrating adsorption locations of a first adsorption inhibitor in the recess of the substrate, FIG. 4D is a diagram schematically illustrating adsorption locations of a first adsorption promoter in the recess of the substrate, FIG. 4E is a diagram schematically illustrating adsorption locations of the first adsorption inhibitor in the recess of the substrate, and FIG. 4F is a diagram schematically illustrating adsorption locations of a reactive gas in the recess of the substrate.
FIG. 5 is a flow chart schematically illustrating a substrate processing according to a first modified example of the present disclosure.
FIG. 6A is a diagram schematically illustrating a process sequence when the source gas is supplied according to a second modified example of the present disclosure, FIG. 6B is a diagram schematically illustrating a process sequence when the source gas is supplied according to a third modified example of the present disclosure, and FIG. 6C is a diagram schematically illustrating a process sequence when the source gas is supplied according to a fourth modified example of the present disclosure.

### [Detailed Description]

### <Embodiments of Present Disclosure>

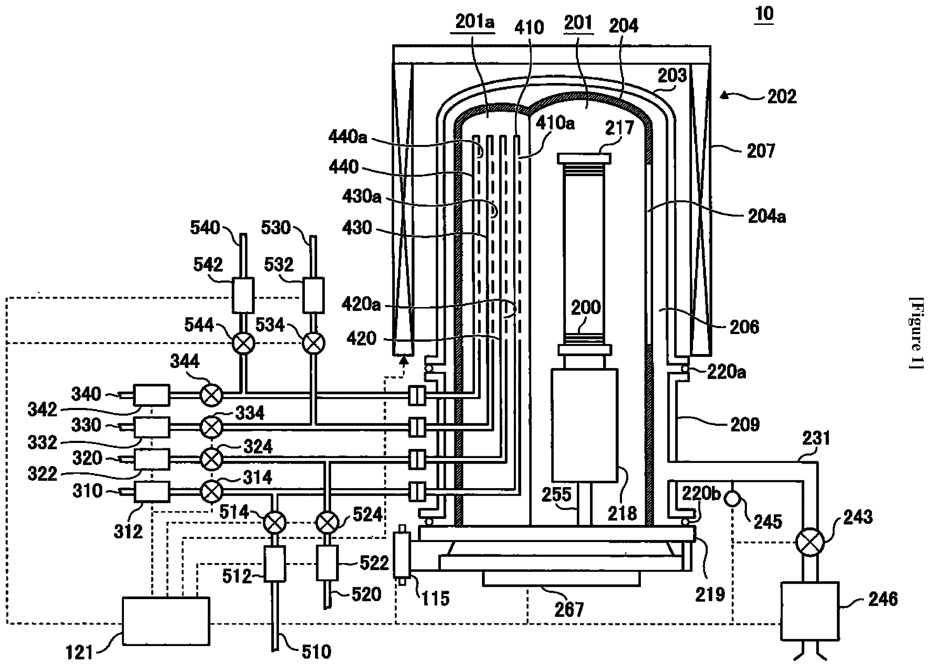

Hereinafter, one or more embodiments (hereinafter, also simply referred to as "embodiments") according to the present disclosure will be described with reference to FIGS. 1 to 6C. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

A substrate processing apparatus 10 according to the present embodiments includes a process furnace 202 provided with a heater 207 serving as a heating structure (which is a heating apparatus or a heating system). For example, the heater 207 is of a cylindrical shape, and is vertically installed while being supported by a heater base (not shown) serving as a support plate.

An outer tube 203 constituting a process vessel is provided in an inner side of the heater 207 to be aligned in a manner concentric with the heater 207. For example, the outer tube 203 is made of a heat resistant material such as quartz and silicon carbide (SiC). For example, the outer tube 203 is of a cylindrical shape with a closed upper end and an open lower end. A manifold 209 (hereinafter, also referred to as an "MF 209") is provided under the outer tube 203 to be aligned in a manner concentric with the outer tube 203. For example, the MF 209 is made of a metal such as stainless steel. For example, the MF 209 is of a cylindrical shape with open upper and lower ends. An O-ring 220a serving as a seal is provided between an upper end portion of the MF 209 and the outer tube 203. As the MF 209 is supported by the heater base, the outer tube 203 is installed vertically.

An inner tube 204 constituting the process vessel is provided in an inner side of the outer tube 203. For example, the inner tube 204 is made of a heat resistant material such as quartz and silicon carbide (SiC). For example, the inner tube 204 is of a cylindrical shape with a closed upper end and an open lower end. The process vessel is constituted mainly by the outer tube 203, the inner tube 204 and the MF 209. A process chamber 201 is provided in a hollow cylindrical portion of the process vessel (that is, an inside (inner portion) of the inner tube 204).

The process chamber 201 is configured to be capable of accommodating a plurality of wafers 200 in a horizontal orientation to be vertically arranged in a multistage manner by a boat 217 described later. Hereinafter, each of the plurality of wafers 200 may also be simply referred to as a "wafer 200" which serves as a substrate.

Nozzles 410, 420, 430 and 440 are installed in the process chamber 201 so as to penetrate a side wall of the MF 209 and the inner tube 204. Gas supply pipes 310, 320, 330 and 340 are connected to the nozzles 410, 420, 430 and 440, respectively. However, the process furnace 202 according to the present embodiments is not limited to such a configuration mentioned above.

Mass flow controllers (also simply referred to as "MFCs") 312, 322, 332 and 342 serving as flow rate controllers (flow rate control structures) and valves 314, 324, 334 and 344 serving as opening/closing valves are sequentially installed at the gas supply pipes 310, 320, 330 and 340, respectively, in this order from upstream sides to downstream sides of the gas supply pipes 310, 320, 330 and 340 in a gas flow direction. Gas supply pipes 510, 520, 530 and 540 through which an inert gas is supplied are connected to the gas supply pipes 310, 320, 330 and 340, respectively, at downstream sides of the valves 314, 324, 334 and 344. MFCs 512, 522, 532 and 542 and valves 514, 524, 534 and 544 are sequentially installed at the gas supply pipes 510, 520, 530 and 540, respectively, in this order from upstream sides to downstream sides of the gas supply pipes 510, 520, 530 and 540 in the gas flow direction.

The nozzles 410, 420, 430 and 440 are connected to front ends (tips) of the gas supply pipes 310, 320, 330 and 340, respectively. Each of the nozzles 410, 420, 430 and 440 may be configured as an L-shaped nozzle. Horizontal portions of the nozzles 410, 420, 430 and 440 are installed so as to penetrate the side wall of the MF 209 and the inner tube 204. Vertical portions of the nozzles 410, 420, 430 and 440 are installed in a preliminary chamber 201a of a channel shape (a groove shape) protruding outward in a radial direction of the inner tube 204 and extending in a vertical direction. That is, the vertical portions of the nozzles 410, 420, 430 and 440 are installed in the preliminary chamber 201a to extend upward (in a direction in which the wafers 200 are arranged) along an inner wall of the inner tube 204.

The nozzles 410, 420, 430 and 440 extend from a lower region of the process chamber 201 to an upper region of the process chamber 201. The nozzles 410, 420, 430 and 440 are provided with a plurality of gas supply holes 410a, a plurality of gas supply holes 420a, a plurality of gas supply holes 430a and a plurality of gas supply holes 440a, respectively, at positions facing the wafers 200. Thereby, process gases can be supplied to the wafers 200 through the gas supply holes 410a of the nozzle 410, the gas supply holes 420a of the nozzle 420, the gas supply holes 430a of the nozzle 430 and the gas supply holes 440a of the nozzle 440, respectively. The gas supply holes 410a, the gas supply holes 420a, the gas supply holes 430a and the gas supply holes 440a are provided from a lower portion to an upper portion of the inner tube 204. An opening area of each of the gas supply holes 410a, the gas supply holes 420a, the gas supply holes 430a and the gas supply holes 440a is the same, and each of the gas supply holes 410a, the gas supply holes 420a, the gas supply holes 430a and the gas supply holes 440a is provided at the same pitch.

A source gas (which serves as one of the process gases) is supplied into the process chamber 201 through the gas supply pipe 310 provided with the MFC 312 and the valve 314 and the nozzle 410.

A reactive gas (which serves as one of the process gases) is supplied into the process chamber 201 through the gas supply pipe 320 provided with the MFC 322 and the valve 324 and the nozzle 420. Hereinafter, each of the process gases may also be referred to as a "process gas".

A first adsorption inhibitor (which serves as a first adsorption inhibiting agent) or a second adsorption inhibitor (which serves as a second adsorption inhibiting agent) is supplied into the process chamber 201 through the gas supply pipe 330 provided with the MFC 332 and the valve 334 and the nozzle 430.

A first adsorption promoter (which serves as a first adsorption promoting agent) is supplied into the process chamber 201 through the gas supply pipe 340 provided with the MFC 342 and the valve 344 and the nozzle 440.

In the present specification, the term "agent" may contain at least one selected from the group of a gaseous substance and a liquid substance. The liquid substance may contain a mist substance. That is, an agent (such as an adsorption inhibiting agent, an adsorption promoting agent, a film forming agent, a modifying agent and an etching agent) may contain a gaseous substance, may contain a liquid substance such as a mist substance, or may contain both of the gaseous substance and the liquid substance.

The inert gas is supplied into the process chamber 201 through the gas supply pipes 510, 520, 530 and 540 provided with the MFCs 512, 522, 532 and 542 and the valves 514, 524, 534 and 544, respectively, and the nozzles 410, 420, 430 and 440.

A process gas supplier (which is a process gas supply structure or a process gas supply system) is constituted mainly by the gas supply pipes 310, 320, 330 and 340, the MFCs 312, 322, 332 and 342, the valves 314, 324, 334 and 344 and the nozzles 410, 420, 430 and 440. However, the process gas supplier may be constituted by the nozzles 410, 420, 430 and 440 without including other components mentioned above. The process gas supplier may also be simply referred to as a "gas supplier" which is a gas supply structure or a gas supply system. When the source gas is supplied through the gas supply pipe 310, a source gas supplier (which is a source gas supply structure or a source gas supply system) is constituted mainly by the gas supply pipe 310, the MFC 312 and the valve 314. For example, the source gas supplier may further include the nozzle 410. In addition, when the reactive gas is supplied through the gas supply pipe 320, a reactive gas supplier (which is a reactive gas supply structure or a reactive gas supply system) is constituted mainly by the gas supply pipe 320, the MFC 322 and the valve 324. For example, the reactive gas supplier may further include the nozzle 420. In addition, when the first adsorption inhibitor or the second adsorption inhibitor is supplied through the gas supply pipe 330, an adsorption inhibitor supplier (which is an adsorption inhibitor supply structure or an adsorption inhibitor supply system) is constituted mainly by the gas supply pipe 330, the MFC 332 and the valve 334. For example, the adsorption inhibitor supplier may further include the nozzle 430. In addition, when the first adsorption promoter is supplied through the gas supply pipe 340, an adsorption promoter supplier (which is an adsorption promoter supply structure or an adsorption promoter supply system) is constituted mainly by the gas supply pipe 340, the MFC 342 and the valve 344. For example, the adsorption promoter supplier may further include the nozzle 440. In addition, an inert gas supplier (which is an inert gas supply structure or an inert gas supply system) is constituted mainly by the gas supply pipes 510, 520, 530 and 540, the MFCs 512, 522, 532 and 542 and the valves 514, 524, 534 and 544.

An exhaust hole (which is an exhaust port) 204a is an opening provided at a side wall of the inner tube 204 at a position facing the nozzles 410, 420, 430, and 440. For example, the exhaust hole 204a is of a slit shape. The gas supplied into the process chamber 201 through the gas supply holes 410a of the nozzle 410, the gas supply holes 420a of the nozzle 420, the gas supply holes 430a of the nozzle 430 or the gas supply holes 440a of the nozzle 440 flows over surfaces of the wafers 200. The gas that flowed over the surfaces of the wafers 200 is exhausted through the exhaust hole 204a into an exhaust path 206 (which is constituted by a gap provided between the inner tube 204 and the outer tube 203). The gas after flowing in the exhaust path 206 flows into an exhaust pipe 231, and is then discharged (exhausted) out of the process furnace 202.

The exhaust pipe 231 through which an atmosphere (inner atmosphere) of the process chamber 201 is exhausted is installed at the MF 209. A pressure sensor 245 serving as a pressure detector (pressure detecting structure) configured to detect a pressure (inner pressure) of the process chamber 201, an APC (Automatic Pressure Controller) valve 243 and a pump 246 serving as an exhaust apparatus are sequentially connected to the exhaust pipe 231 in this order from an upstream side to a downstream side of the exhaust pipe 231 in the gas flow direction. With the pump 246 in operation, the APC valve 243 may be opened or closed to perform an exhaust of the process chamber 201 or stop the exhaust. In addition, with the pump 246 in operation, an opening degree of the APC valve 243 may be adjusted in order to adjust the inner pressure of the process chamber 201. An exhauster (which is an exhaust structure or an exhaust system) is constituted mainly by the exhaust hole 204a, the exhaust path 206, the exhaust pipe 231, the APC valve 243 and the pressure sensor 245. The exhauster may further include the pump 246.

A seal cap 219 (hereinafter, also referred to as an "SC 219") serving as a furnace opening lid capable of airtightly sealing (closing) a lower end opening of the MF 209 is provided under the MF 209. An O-ring 220b serving as a seal is provided on an upper surface of the SC 219 so as to be in contact with the lower end of the MF 209. A rotator (which is a rotating structure) 267 configured to rotate the boat 217 accommodating the wafers 200 is provided at the SC 219 in a manner opposite to the process chamber 201. A rotating shaft 255 of the rotator 267 is connected to the boat 217 through the SC 219. The SC 219 is configured to be elevated or lowered in the vertical direction by a boat elevator 115 (hereinafter, also referred to as a "BE 115") serving as an elevating structure vertically provided outside the outer tube 203. The BE 115 serves as a transfer structure (transfer system) capable of transferring (loading) the boat 217 and the wafers 200 accommodated in the boat 217 into the process chamber 201 and capable of transferring (unloading) the boat 217 and the wafers 200 accommodated in the boat 217 out of the process chamber 201.

The boat 217 serving as a substrate support (substrate retainer) is configured to accommodate (or support) the wafers 200 (for example, from 10 wafers to 200 wafers) while the wafers 200 are horizontally oriented with their centers aligned with one another with a predetermined interval therebetween in the vertical direction. For example, the boat 217 is made of a heat resistant material such as quartz and SiC. For example, a heat insulating cylinder 218 made of a heat resistant material such as quartz and SiC is provided under the boat 217.

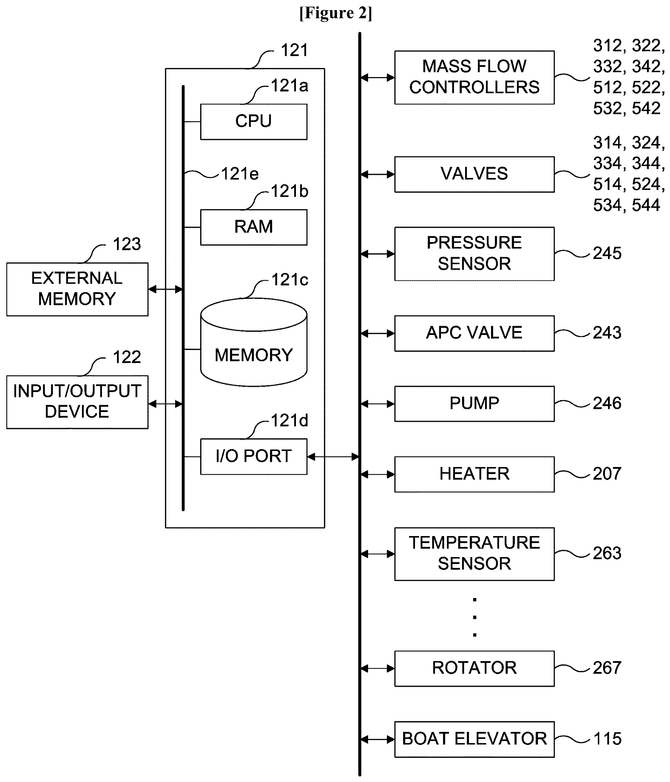

A temperature sensor 263 (see FIG. 2) serving as a temperature detector is installed in the inner tube 204. An amount of the electric current supplied (or applied) to the heater 207 is adjusted based on temperature information detected by the temperature sensor 263 such that a desired temperature distribution of a temperature (inner temperature) of the process chamber 201 can be obtained.

As shown in FIG. 2, a controller 121 serving as a control structure (or a control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the controller 121.

For example, the memory 121c is configured by a component such as a flash memory and a hard disk drive (HDD). For example, a control program configured to control an operation of the substrate processing apparatus 10 and a process recipe containing information on procedures and conditions of a method of manufacturing a semiconductor device described later may be readably stored in the memory 121c. The process recipe is obtained by combining steps (procedures) of the method of manufacturing the semiconductor device described later such that the controller 121 can execute the steps to acquire a predetermined result, and functions as a program. Hereinafter, the process recipe and the control program may be collectively or individually referred to as a "program". Thus, in the present specification, the term "program" may refer to the process recipe alone, may refer to the control program alone or may refer to a combination of the process recipe and the control program. The RAM 121b functions as a memory area (work area) where a program or data read by the CPU 121a is temporarily stored.

The I/O port 121d is connected to components described above such as the MFCs 312, 322, 332, 342, 512, 522, 532 and 542, the valves 314, 324, 334, 344, 514, 524, 534 and 544, the pressure sensor 245, the APC valve 243, the pump 246, the heater 207, the temperature sensor 263, the rotator 267 and the BE 115.

The CPU 121a is configured to be capable of reading the control program from the memory 121c and executing the control program read from the memory 121c. In addition, the CPU 121a is further configured to be capable of reading the process recipe from the memory 121c in accordance with an operation command inputted from the input/output device 122. In accordance with contents of the process recipe read from the memory 121c, the CPU 121a is configured to be capable of controlling various operations such as flow rate adjusting operations for various gases by the MFCs 312, 322, 332, 342, 512, 522, 532 and 542, opening and closing operations of the valves 314, 324, 334, 344, 514, 524, 534 and 544, an opening and closing operation of the APC valve 243, a pressure adjusting operation by the APC valve 243 based on the pressure sensor 245, a temperature adjusting operation by the heater 207 based on the temperature sensor 263, a start and stop operation of the pump 246, an operation of adjusting a rotation and a rotation speed of the boat 217 by the rotator 267, an elevating and lowering operation of the boat 217 by the BE 115 and an operation of accommodating the wafer 200 into the boat 217.

The controller 121 may be embodied by installing the above-described program stored in an external memory 123 into the computer. For example, the external memory 123 may include one or more among a magnetic disk such as a hard disk, an optical disk such as a CD and a DVD and a semiconductor memory such as a flash memory. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program (program product) to the computer.

### (2) Substrate Processing (Substrate Processing Method)

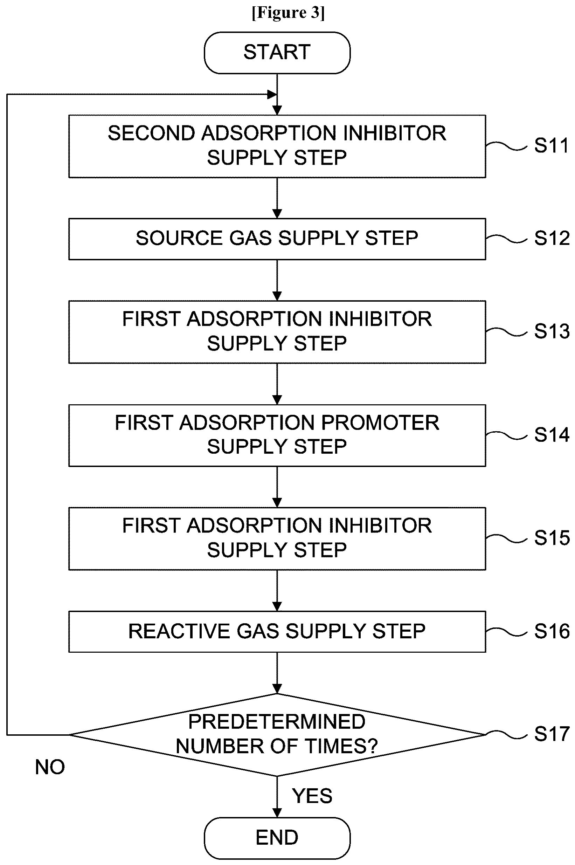

Hereinafter, an example of a substrate processing, that is, a step of forming a first element-containing film on the wafer 200 with a concave structure (three-dimensional structure) 300 such as a trench, a groove and a hole formed on the surface thereof, which is a part of a manufacturing process of a semiconductor device, will be described mainly with reference to FIG. 3 and FIGS. 4A to 4F. Hereinafter, the concave structure 300 may also be referred to as a "recess 300". The substrate processing is performed by using the process furnace 202 of the substrate processing apparatus 10 described above. In the following description, operations of components constituting the substrate processing apparatus 10 are controlled by the controller 121.

The substrate processing (that is, the manufacturing process of the semiconductor device) according to the present embodiments may include:
(a) a step of supplying the source gas;
(b) a step of supplying the first adsorption promoter;
(c) a step of supplying the reactive gas;
(d) a step of forming the film on the wafer 200 by sequentially performing (a), (b) and (c) a predetermined number of times; and
(e) a step of supplying the first adsorption inhibitor in (d),
wherein (e) is performed before (b) or after (b), or (e) is performed before (b) and after (b).

In the present specification, for convenience of explanation, such process sequences mentioned above may be illustrated as follows. Similar notations will be used in explanations of modified examples described later.
(Source gas → P → First adsorption inhibitor → P → First adsorption promoter → P → First adsorption inhibitor → P → Reactive gas → P) × n => First element-containing film
(Source gas → P → First adsorption inhibitor → P → First adsorption promoter → P → Reactive gas → P) × n => First element-containing film
(Source gas → P → First adsorption promoter → P → First adsorption inhibitor → P → Reactive gas → P) × n => First element-containing film

In the present specification, the symbol "P" indicates that a purge process of purging the process chamber 201 is performed.

The present embodiments will be described by way of an example in which a step of supplying the second adsorption inhibitor is performed before (a), and (e) is performed before (b) and after (b), as shown below.

(Second adsorption inhibitor → P → Source gas → P → First adsorption inhibitor → P → First adsorption promoter → P → First adsorption inhibitor → P → Reactive gas → P) × n => First element-containing film.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". In the present specification, the terms "substrate" and "wafer" may be used as substantially the same meaning.

### <Wafer Loading Step>

First, the plurality of wafers 200 are loaded into the boat 217. In such an operation, the wafers 200 are loaded with an interval wider than the predetermined interval. That is, the interval between adjacent wafers among the wafers 200 is set to be wider than that when the wafers 200 are continuously loaded into the boat 217. Thereby, it is possible to reduce an effect of reaction by-products on the wafers 200. After the wafers 200 are charged (loaded or transferred) into the boat 217, as shown in FIG. 1, the boat 217 supporting the wafers 200 is elevated by the BE 115 and loaded (transferred) into the process chamber 201 of the process vessel such that the boat 217 is accommodated in the process vessel.

### <Pressure Adjusting and Temperature Adjusting Step >

Then, the pump 246 exhausts the inner atmosphere of the process chamber 201 (that is, a space in which the wafers 200 are present (accommodated)) such that the inner pressure of the process chamber 201 reaches and is maintained at a desired pressure. In such an operation, the inner pressure of the process chamber 201 is measured by the pressure sensor 245, and the APC valve 243 is feedback-controlled based on pressure information measured by the pressure sensor 245 (pressure adjusting). The pump 246 continuously exhausts the inner atmosphere of the process chamber 201 until at least a processing of the wafer 200 is completed. In addition, the heater 207 heats the process chamber 201 such that the inner temperature of the process chamber 201 reaches and is maintained at a desired process temperature. In such an operation, the amount of the electric current supplied to the heater 207 is feedback-controlled based on the temperature information detected by the temperature sensor 263 such that the desired temperature distribution of the inner temperature of the process chamber 201 can be obtained (temperature adjusting). The heater 207 continuously heats the process chamber 201 until at least the processing of the wafer 200 is completed.

### <Film Forming Process>

As a film forming process, the following steps S11 to S17 are performed.

### <Second Adsorption Inhibitor Supply Step, S11>

The valve 334 is opened to supply the second adsorption inhibitor into the gas supply pipe 330. After a flow rate of the second adsorption inhibitor is adjusted by the MFC 332, the second adsorption inhibitor whose flow rate is adjusted is supplied into the process chamber 201 through the gas supply holes 430a of the nozzle 430, and is exhausted through the exhaust pipe 231. In such an operation, the valves 514 to 544 may be opened to supply the inert gas into the process chamber 201 through each of the nozzles 410 to 440.

For example, process conditions when supplying the second adsorption inhibitor in the present step are as follows:
A process temperature: from 300 °C to 600 °C, preferably from 400 °C to 560 °C, and more preferably from 450 °C to 530 °C;
A process pressure: from 1 Pa to 3,990 Pa;
A supply flow rate of the second adsorption inhibitor: from 0.1 slm to 1,000 slm;
A supply time (time duration) of supplying the second adsorption inhibitor: from 0.01 second to 180 seconds; and
A supply flow rate of the inert gas (for each nozzle): from 0.1 slm to 30 slm.

For example, it is preferable that the process temperature is set to be substantially the same in the entirety of the following steps. In addition, in the present specification, the term "process temperature" may refer to a "temperature of the wafer 200" or the "inner temperature of the process chamber 201", and the term "process pressure" may refer to the "inner pressure of the process chamber 201". In addition, the term "process time" refers to a time duration of continuously performing a process related thereto. The same also applies to the following description. In the present specification, a notation of a numerical range such as "300 °C to 600 °C" means that a lower limit and an upper limit thereof are included in the numerical range. Therefore, for example, the numerical range "300 °C to 600 °C" means a range equal to or higher than 300 °C and equal to or lower than 600 °C. The same also applies to other numerical ranges described herein. In addition, when a supply flow rate of a substance (gas) includes "0 slm", it refers to a case where the substance (gas) is not supplied. The same also applies to the following description.

In the present step, the second adsorption inhibitor is supplied to the wafer 200. As a result, as shown in FIG. 4A, the second adsorption inhibitor or a part of molecules of the second adsorption inhibitor (hereinafter, also referred to as a "second adsorption inhibiting substance") can be adsorbed onto an upper surface and an upper inner surface of the recess 300. The second adsorption inhibiting substance is preferentially adsorbed onto the upper surface and the upper inner surface (also referred to as an "opening side") of the recess 300, rather than onto a lower inner surface (also referred to as a "bottom side") of the recess 300. Thereby, it is possible to suppress an adsorption of the source gas supplied in the subsequent step S12 onto the opening side of the recess 300.

The second adsorption inhibitor is a gas capable of inhibiting the adsorption of the source gas supplied in the subsequent step S12 onto the wafer 200. As the second adsorption inhibitor, for example, a gas containing a halogen element may be used.

As the halogen element, for example, an element such as chlorine (Cl), fluorine (F), iodine (I) and bromine (Br) may be used. As the halogen element, for example, one or more of the elements exemplified above may be used. As the halogen element, preferably, fluorine may be used.

As a gas containing fluorine (that is, a fluorine-containing gas), for example, a gas such as tungsten fluoride (WF₆) gas, chlorine fluoride (ClF₃) gas, nitrogen trifluoride (NF₃) gas, hydrogen fluoride (HF) gas and fluorine (F₂) gas may be used. As the gas containing fluorine, for example, one or more of the gases exemplified above may be used.

As the inert gas, for example, nitrogen (N₂) gas or a rare gas such as argon (Ar) gas, helium (He) gas, neon (Ne) gas and xenon (Xe) gas may be used. As the inert gas, for example, one or more of the gases exemplified above may be used. The same also applies to each step described below.

For example, when the WF₆ gas is used as the second adsorption inhibitor, by supplying the WF₆ gas, WFx1 (wherein x1 is an integer of 6 or less) or fluorine can be adsorbed onto the upper surface and the upper inner surface of the recess 300 of the wafer 200.

After the second adsorption inhibiting substance is adsorbed onto the upper surface and the upper inner surface of the recess 300 on the surface of the wafer 200, the valve 334 is closed to stop a supply of the second adsorption inhibitor into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the second adsorption inhibitor) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as a purge gas. Thereby, the process chamber 201 is purged (purge operation).

### <Source Gas Supply Step, S12>

The valve 314 is opened to supply the source gas into the gas supply pipe 310. After a flow rate of the source gas is adjusted by the MFC 312, the source gas whose flow rate is adjusted is supplied into the process chamber 201 through the gas supply holes 410a of the nozzle 410, and is exhausted through the exhaust pipe 231. In such an operation, the valves 514 to 544 may be opened to supply the inert gas into the process chamber 201 through each of the nozzles 410 to 440.

For example, process conditions when supplying the source gas in the present step are as follows:
A supply flow rate of the source gas: from 0.1 slm to 2.0 slm; and
A supply time (time duration) of supplying the source gas: from 0.01 second to 60 seconds.

Other process conditions thereof may be set to be the same (substantially the same) as those of the step S11. The same also applies to each step described below.

In the present step, the source gas is supplied to the wafer 200 after the second adsorption inhibiting substance is adsorbed onto the upper surface and the upper inner surface of the recess 300 on the surface of the wafer 200. As a result, as shown in FIG. 4B, the source gas or a part of molecules of the source gas is adsorbed onto the lower inner surface of the recess 300 to which the second adsorption inhibiting substance is not adsorbed. Thereby, a first layer containing a first element can be formed in sequence from the bottom side of the recess 300. In other words, the source gas is less likely to be adsorbed onto the upper surface and the upper inner surface of the recess 300 to which the second adsorption inhibiting substance is adsorbed. Therefore, the source gas is preferentially adsorbed to the bottom side of the recess 300 to which the second adsorption inhibiting substance is not adsorbed, rather than the opening side of the recess 300 to which the second adsorption inhibiting substance is adsorbed. Thereby, the first layer containing the first element can be formed in sequence from the bottom side of the recess 300.

As the source gas, for example, a gas containing the first element and a halogen element (herein, also referred to as a "third halogen") may be used.

As the first element, for example, an element such as titanium (Ti), zirconium (Zr), hafnium (Hf), molybdenum (Mo), ruthenium (Ru), aluminum (Al), gallium (Ga), silicon (Si) and germanium (Ge) may be used. As the first element, for example, one or more of the elements exemplified above may be used.

As the third halogen, for example, an element such as chlorine (Cl), fluorine (F), bromine (Br) and iodine (I) may be used. As the third halogen, for example, one or more of the elements exemplified above may be used.

As the gas containing the first element and the third halogen, for example, a gas such as titanium tetrachloride (TiCl₄) gas, titanium tetrafluoride (TiF₄) gas, hexachlorotungsten (WCl_{b}) gas, hexafluorotungsten (WF₆) gas, molybdenum pentachloride (MoCl₅) gas, molybdenum pentafluoride (MoF₅) gas, molybdenum dioxide dichloride (MoO₂Cl₂) gas, molybdenum oxide tetrachloride (MoOCl₄) gas, ruthenium trichloride (RuCl₃) gas, ruthenium trifluoride (RuF₃) gas, hafnium tetrachloride (HfCl₄) gas, hafnium tetrafluoride (HfF₄) gas, zirconium tetrachloride (ZrCl₄) gas, zirconium tetrafluoride (ZrF₄) gas, aluminum trichloride (AlCl₃) gas, aluminum trifluoride (AlF₃) gas, dichlorosilane (SiH₂Cl₂) gas, tetrachlorosilane (SiCl₄) gas and hexachlorodisilane (Si₂Cl₆) gas may be used. As the gas containing the first element and the third halogen, for example, one or more of the gases exemplified above may be used.

For example, when the TiCl₄ gas is used as the source gas, by supplying the TiCl₄ gas, TiClx2 (wherein x2 is an integer of 4 or less) or chlorine can be adsorbed onto the lower inner surface of the recess 300 of the wafer 200. Thereby, a titanium-containing layer serving as the first layer can be formed.

After the first layer is formed on the lower inner surface of the recess 300 on the surface of the wafer 200, the valve 314 is closed to stop a supply of the source gas into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the source gas) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

### <First Adsorption Inhibitor Supply Step, S13>

The valve 334 is opened to supply the first adsorption inhibitor into the gas supply pipe 330. After a flow rate of the first adsorption inhibitor is adjusted by the MFC 332, the first adsorption inhibitor whose flow rate is adjusted is supplied into the process chamber 201 through the gas supply holes 430a of the nozzle 430, and is exhausted through the exhaust pipe 231. In such an operation, the valves 514 to 544 may be opened to supply the inert gas into the process chamber 201 through each of the nozzles 410 to 440.

For example, process conditions when supplying the first adsorption inhibitor in the present step are as follows:
A supply flow rate of the first adsorption inhibitor: from 0.01 slm to 3 slm; and
A supply time (time duration) of supplying the first adsorption inhibitor: from 0.01 second to 120 seconds.

In the present step, the first adsorption inhibitor is supplied to the wafer 200 after the first layer is formed on the lower inner surface of the recess 300. As a result, as shown in FIG. 4C, the first adsorption inhibitor or a part of molecules of the first adsorption inhibitor (hereinafter, also referred to as a "first adsorption inhibiting substance") can be adsorbed onto the upper surface and the upper inner surface of the recess 300. The first adsorption inhibiting substance is preferentially adsorbed onto the upper surface and the upper inner surface of the recess 300, rather than onto the lower inner surface of the recess 300. Thereby, it is possible to suppress an adsorption of the first adsorption promoter supplied in the subsequent step S14 onto the opening side of the recess 300.

The first adsorption inhibitor is a gas capable of inhibiting the adsorption of the first adsorption promoter supplied in the subsequent step S14 onto the wafer 200. In addition, the first adsorption inhibitor is a gas different from the second adsorption inhibitor described above. As the first adsorption inhibitor, for example, a gas containing a halogen element (herein, also referred to as a "first halogen") may be used.

As the first halogen, for example, an element such as chlorine (Cl), fluorine (F), bromine (Br) and iodine (I) may be used. As the first halogen, for example, one or more of the elements exemplified above may be used. The first halogen may be the same halogen element as the third halogen described above. As the first halogen, preferably, chlorine may be used.

As the gas containing the first halogen, for example, a gas such as F₂ gas, NF₃ gas, ClF₃ gas, WF₆ gas, bromine (Br₂) gas, iodine (I₂) gas, hydrogen chloride (HCl) gas, hydrogen bromide (HBr) gas, hydrogen iodide (HI) gas, boron trichloride (BCl₃) gas, tungsten chloride (WCl₆) gas, molybdenum chloride (MoCl₃, MoCl₅) gas and chlorine (Cl₂) gas may be used. As the gas containing the first halogen, for example, one or more of the gases exemplified above may be used. As the gas containing the first halogen, preferably, a gas containing chlorine may be used. The first halogen may be the same halogen element as the third halogen described above.

For example, when the HCl gas is used as the first adsorption inhibitor, by supplying the HCl gas, HClx₃ (wherein x3 is an integer of 3 or less) or chlorine can be adsorbed onto the upper surface and the upper inner surface of the recess 300 of the wafer 200.

After the first adsorption inhibiting substance is adsorbed onto the upper surface and the upper inner surface of the recess 300 on the surface of the wafer 200, the valve 334 is closed to stop a supply of the first adsorption inhibitor into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the first adsorption inhibitor) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

### <First Adsorption Promoter Supply Step, S14>

The valve 344 is opened to supply the first adsorption promoter into the gas supply pipe 340. After a flow rate of the first adsorption promoter is adjusted by the MFC 342, the first adsorption promoter whose flow rate is adjusted is supplied into the process chamber 201 through the gas supply holes 440a of the nozzle 440, and is exhausted through the exhaust pipe 231. In such an operation, the valves 514 to 544 may be opened to supply the inert gas into the process chamber 201 through each of the nozzles 410 to 440.

For example, process conditions when supplying the first adsorption promoter in the present step are as follows:
A supply flow rate of the first adsorption promoter: from 0.01 slm to 10 slm; and
A supply time (time duration) of supplying the first adsorption promoter: from 0.01 second to 120 seconds.

In the present step, the first adsorption promoter is supplied to the wafer 200 after the first adsorption inhibiting substance is adsorbed onto the upper surface and the upper inner surface of the recess 300 and the first layer is formed on the lower inner surface of the recess 300. As a result, as shown in FIG. 4D, the first adsorption promoter or a part of molecules of the first adsorption promoter (hereinafter, also referred to as a "first adsorption promoting substance") can be adsorbed onto the part of the molecules of the source gas adsorbed onto the lower inner surface of the recess 300 where the first adsorption inhibiting substance is not adsorbed. In other words, the first adsorption promoter is less likely to be adsorbed onto the upper surface and the upper inner surface of the recess 300 because the first adsorption inhibiting substance is adsorbed thereto. In addition, since the adsorption of the first adsorption promoter onto the bottom side of the recess 300 where the first adsorption inhibiting substance is not adsorbed can be promoted, a ligand of the source gas adsorbed to the bottom side of the recess 300 can be replaced with a part of the first adsorption promoter.

The first adsorption promoter is a gas capable of promoting an adsorption of the reactive gas supplied in the step S16 described later onto the wafer 200. As the first adsorption promoter, for example, a gas containing a halogen element (herein, also referred to as a "second halogen") may be used.

As the second halogen, for example, an element such as chlorine (Cl), fluorine (F), bromine (Br) and iodine (I) may be used. As the second halogen, for example, one or more of the elements exemplified above may be used. The second halogen may be a halogen element different from the first halogen and third halogen described above. As the second halogen, preferably, iodine may be used.

As a gas containing iodine, for example, a gas such as HI gas, methyl iodide (CH₃I) gas, ethyl iodide (C₂H₅I) gas, propyl iodide (C₃H₇I) gas, butyl iodide (C₄H₉I) gas, isopropyl iodide gas and tertiary butyl iodide gas may be used. As the gas containing iodine, for example, one or more of the gases exemplified above may be used.

For example, when the HI gas is used as the first adsorption promoter, by supplying the HI gas, chemical substitution by hydrogen (H) or iodine (I) takes place in the TiClx2 adsorbed to the bottom side of the recess 300 on the wafer 200. Specifically, for example, hydrogen or iodine replaces chlorine (Cl) in a titanium - chlorine bond (Ti - Cl bond) adsorbed to the bottom side of the recess 300. As a result, a titanium - iodine bond (Ti - I bond) or a titanium - hydrogen bond (Ti - H bond) can be formed.

After the first adsorption promoting substance is adsorbed onto the lower inner surface of the recess 300 on the surface of the wafer 200, the valve 344 is closed to stop a supply of the first adsorption promoter into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the first adsorption promoter) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

### <First Adsorption Inhibitor Supply Step, S15>

Similar to the step S13 described above, the valve 334 is opened to supply the first adsorption inhibitor into the gas supply pipe 330. After a flow rate of the first adsorption inhibitor in the present step is adjusted by the MFC 332, the first adsorption inhibitor whose flow rate is adjusted is supplied into the process chamber 201 through the gas supply holes 430a of the nozzle 430, and is exhausted through the exhaust pipe 231. In such an operation, the valves 514 to 544 may be opened to supply the inert gas into the process chamber 201 through each of the nozzles 410 to 440.

For example, process conditions when supplying the first adsorption inhibitor in the present step are as follows:
A supply flow rate of the first adsorption inhibitor: from 0.01 slm to 3 slm; and
A supply time (time duration) of supplying the first adsorption inhibitor: from 0.01 second to 120 seconds.

In the present step, the first adsorption inhibitor is supplied to the wafer 200 after the ligand of the source gas adsorbed onto the lower inner surface of the recess 300 is replaced with the part of the first adsorption promoter. As a result, as shown in FIG. 4E, the first adsorption inhibiting substance can be adsorbed onto the upper surface and the upper inner surface of the recess 300. By supplying the first adsorption promoter in the step S14 described above, the first adsorption inhibiting substance adsorbed onto the upper surface and the upper inner surface of the recess 300 in the step S13 may react and desorb. In the present step, the first adsorption inhibiting substance is again adsorbed onto the upper surface and the upper inner surface of the recess 300. The first adsorption inhibiting substance is preferentially adsorbed onto the upper surface and the upper inner surface of the recess 300, rather than onto the lower inner surface of the recess 300. Thereby, it is possible to suppress the adsorption of the reactive gas supplied in the subsequent step S16 onto the upper surface and the upper inner surface of the recess 300.

As the first adsorption inhibitor, for example, the gas used in the step S13 described above may be used in the same manner.

For example, when the HCl gas is used as the first adsorption inhibitor, by supplying the HCl gas, HClx₃ (wherein x3 is an integer of 3 or less) or chlorine can be adsorbed onto the upper surface and the upper inner surface of the recess 300 of the wafer 200.

After the first adsorption inhibiting substance is adsorbed onto the upper surface and the upper inner surface of the recess 300 on the surface of the wafer 200, the valve 334 is closed to stop a supply of the first adsorption inhibitor in the present step into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the first adsorption inhibitor) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

According to the present embodiments, an amount (also referred to as a "supply amount") of the first adsorption inhibitor supplied in the step S13 described above is set to be less than an amount of the first adsorption promoter supplied in the step S14 described above. By setting the supply amount of the first adsorption inhibitor to be less than the supply amount of the first adsorption promoter, it is possible to suppress a desorption of the first adsorption promoter adsorbed onto the bottom side of the recess 300.

Specifically, a time duration (supply time) of supplying the first adsorption inhibitor in the step S13 described above is set to be shorter than a time duration (supply time) of supplying the first adsorption promoter in the step S14 described above. For example, the flow rate (supply flow rate) of the first adsorption inhibitor supplied in the step S13 described above may be set to be less than the flow rate (supply flow rate) of the first adsorption promoter supplied in the step S14 described above. For example, a partial pressure of the first adsorption inhibitor supplied in the step S13 described above may be set to be lower than a partial pressure of the first adsorption promoter supplied in the step S14 described above. For example, the supply times, the supply flow rates and the partial pressures of the first adsorption inhibitor in the step S13 and the first adsorption promoter in the step S14 may be appropriately combined to set the supply amount of the first adsorption inhibitor in the step S13 to be less than the supply amount of the first adsorption promoter in the step S14. By utilizing the characteristics of Knudsen diffusion, it is preferable to adjust the supply time such that the supply time of the first adsorption promoter is longer than the supply time of the first adsorption inhibitor.

Similarly, the supply amount of the first adsorption inhibitor in the step S15 described above is set to be less than the supply amount of the first adsorption promoter in the step S14 described above. By setting the supply amount of the first adsorption inhibitor to be less than the supply amount of the first adsorption promoter, it is possible to suppress the desorption of the first adsorption promoter adsorbed onto the bottom side of the recess 300.

Specifically, a time duration (supply time) of supplying the first adsorption inhibitor in the step S15 described above is set to be shorter than the time duration (supply time) of supplying the first adsorption promoter in the step S14 described above. For example, the flow rate (supply flow rate) of the first adsorption inhibitor supplied in the step S15 described above may be set to be less than the flow rate (supply flow rate) of the first adsorption promoter supplied in the step S14 described above. For example, a partial pressure of the first adsorption inhibitor supplied in the step S15 described above may be set to be lower than the partial pressure of the first adsorption promoter supplied in the step S14 described above. For example, the supply times, the supply flow rates and the partial pressures of the first adsorption inhibitor in the step S15 and the first adsorption promoter in the step S14 may be appropriately combined to set the supply amount of the first adsorption inhibitor in the step S15 to be less than the supply amount of the first adsorption promoter in the step S14. By utilizing the characteristics of Knudsen diffusion, it is preferable to adjust the supply time such that the supply time of the first adsorption promoter is longer than the supply time of the first adsorption inhibitor.

### <Reactive Gas Supply Step, S16>

Subsequently, the valve 324 is opened to supply the reactive gas into the gas supply pipe 320. After a flow rate of the reactive gas is adjusted by the MFC 322, the reactive gas whose flow rate is adjusted is supplied into the process chamber 201 through the gas supply holes 420a of the nozzle 420, and is exhausted through the exhaust pipe 231. In such an operation, the valves 514 to 544 may be opened to supply the inert gas into the process chamber 201 through each of the nozzles 410 to 440.

For example, process conditions when supplying the reactive gas in the present step are as follows:
A supply flow rate of the reactive gas: from 0.1 slm to 30 slm;
A supply time (time duration) of supplying the reactive gas: from 0.01 second to 30 seconds.

In the present step, the reactive gas is supplied to the wafer 200 after the first adsorption inhibiting substance is adsorbed onto the upper surface and the upper inner surface of the recess 300 and after the source gas (whose part of the ligand is replaced with the first adsorption promoting substance) is adsorbed onto the lower inner surface of the recess 300. As a result, as shown in FIG. 4F, the first adsorption promoting substance (which serves as the ligand of the source gas adsorbed to the lower inner surface of the recess 300) is partially replaced by the reactive gas. Thereby, it is possible to form a second layer serving as a modified layer of the first layer. In other words, the reactive gas is less likely to be adsorbed onto the upper surface and the upper inner surface of the recess 300 to which the first adsorption inhibiting substance is adsorbed. Therefore, the reactive gas is preferentially adsorbed to the bottom side of the recess 300 to which the first adsorption promoting substance is adsorbed, rather than the opening side of the recess 300 to which the first adsorption inhibiting substance is adsorbed. Thereby, the first layer can be modified by the reactive gas in sequence from the bottom side of the recess 300 to form the second layer. The reaction by-products generated by modifying the first layer are desorbed from the first layer and exhausted from the process chamber 201.

As the reactive gas, for example, a nitriding agent may be used.

As the nitriding agent (nitriding gas), for example, a gas containing nitrogen (N) and hydrogen (H) may be used. As the gas containing nitrogen and hydrogen, for example, a hydrogen nitride based gas such as ammonia (NH₃) gas, diazene (N₂H₂) gas, hydrazine (N₂H₄) gas and triazane (N₃H₅) gas may be used. As the nitriding agent, for example, one or more of the gases exemplified above may be used. In the present step, when the nitriding agent is used as the reactive gas, the first layer is nitrided and modified into a nitride layer (that is, the second layer).

In addition, as the reactive gas, for example, an oxidizing agent may be used.

As the oxidizing agent (oxidizing gas), for example, a gas containing oxygen (O) and hydrogen (H) may be used. As the gas containing oxygen and hydrogen, for example, water vapor (H₂O) gas, hydrogen peroxide (H₂O₂) gas, a gaseous mixture of hydrogen (H₂) gas and oxygen (O₂) gas and a gaseous mixture of the H₂ gas and ozone (O₃) gas may be used. In addition, as the oxidizing agent, for example, instead of the gas containing oxygen and hydrogen, an oxygen (O)-containing gas may be used. As the oxygen-containing gas, for example, a gas such as the O₂ gas, the O₃ gas, nitrous oxide (N₂O) gas, nitric oxide (NO) gas, nitrogen dioxide (NO₂) gas, carbon monoxide (CO) gas and carbon dioxide (CO₂) gas may be used. For example, the gas containing oxygen and hydrogen may also serve as the oxygen-containing gas. As the oxidizing agent, for example, one or more of the gases exemplified above may be used. In the present step, when the oxidizing agent is used as the reactive gas, the first layer is oxidized and modified into an oxide layer (that is, the second layer).

For example, when the NH₃ gas is used as the reactive gas, by supplying the NH₃ gas, a substitution reaction with the titanium - iodine bond (Ti - I bond) or the titanium - hydrogen bond (Ti - H bond) on the wafer 200 occurs. In such an operation, NH₃ is more likely to react with the Ti - I bond or the Ti - H bond than with the titanium - chlorine bond (Ti - Cl bond), and is more likely to be replaced with a Ti - NH bond. As described above, by supplying the HI gas serving as the first adsorption promoter after the source gas is supplied and before the reactive gas is supplied to form the Ti - I bond or the Ti - H bond on the wafer 200, it is possible to promote the replacement with the Ti - N bond by supplying the NH₃ gas. Thereby, it is possible to uniformly form a TiN layer (that is, the second layer) within the recess 300 on the surface of the wafer 200.

After the second layer is formed within the recess 300 on the surface of the wafer 200, the valve 324 is closed to stop a supply of the reactive gas into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the reactive gas) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

### <Performing Predetermined Number of Times>

By performing a cycle (in which the steps S11 to S16 described above are sequentially performed in this order) a predetermined number of times (n times, n is an integer of 1 or more), it is possible to form the first element-containing film of a predetermined thickness on the wafer 200. According to the present embodiments, for example, a titanium nitride film (TiN film) is formed.

### <Purge Step and Returning to Atmospheric Pressure Step>

Then, the inert gas is supplied into the process chamber 201 through each of the gas supply pipes 510 to 540, and is exhausted through the exhaust pipe 231. The inert gas acts as the purge gas. Thereby, the inner atmosphere of the process chamber 201 is purged with the inert gas. As a result, the gas remaining in the process chamber 201 and the reaction by-products remaining in the process chamber 201 are removed from the process chamber 201. Thereafter, the inner atmosphere of the process chamber 201 is replaced with the inert gas, and the inner pressure of the process chamber 201 is returned to the normal pressure (atmospheric pressure).

### <Wafer Unloading Step>

Thereafter, the SC 219 is lowered by the BE 115 and the lower end of the outer tube 203 is opened. The boat 217 with the wafers 200 (which are processed) charged therein is unloaded out of the outer tube 203 through the lower end of the outer tube 203. Then, the wafers 200 (which are processed) are discharged (transferred) out of the boat 217.

The present embodiments are described by way of an example shown in FIG. 3. As a combination of the second adsorption inhibitor, the source gas, the first adsorption inhibitor, the first adsorption promoter and the reactive gas, for example, the following may be used. A fluorine (F)-containing gas may be used as the second adsorption inhibitor, a chlorine (Cl)-containing gas may be used as the source gas, a fluorine-containing gas may be used as the first adsorption inhibitor, an iodine (I)-containing gas may be used as the first adsorption promoter, and the gas containing nitrogen and hydrogen may be used as the reactive gas. For example, a fluorine-containing gas may be used as the second adsorption inhibitor, a chlorine-containing gas may be used as the source gas, a chlorine-containing gas may be used as the first adsorption inhibitor, an iodine-containing gas may be used as the first adsorption promoter, and an oxygen (O)-containing gas may be used as the reactive gas.

### (3) Effects According to Present Embodiments

According to the present embodiments, it is possible to obtain one or more of the following effects.
(a) It is possible to improve characteristics of the film formed on the wafer 200. In particular, when the film is to be formed on the wafer 200 with the recess 300 formed on the surface thereof, it is possible to improve filling properties of the film formed on the inner surface of the recess 300, and it is also possible to improve a step coverage performance.
(b) By the step S11, it is possible to suppress the adsorption of the source gas onto the upper surface and the upper inner surface of the recess 300 in the subsequent step S12. Thereby, it is possible to easily deliver the source gas to the bottom side of the recess 300.
(c) By the step S13, it is possible to suppress the adsorption of the first adsorption promoting substance onto the upper surface and the upper inner surface of the recess 300 in the subsequent step S14. Thereby, it is possible to easily deliver the first adsorption promoter to the bottom side of the recess 300.
(d) The supply amount of the first adsorption inhibitor in the step S13 or the step S15 is set to be less than the supply amount of the first adsorption promoter in the step S14. Thereby, it is possible to suppress the desorption of the first adsorption promoter adsorbed onto the bottom side of the recess 300.
(e) By the step S15, it is possible to suppress the adsorption of the reactive gas onto the upper surface and the upper inner surface of the recess 300 in the subsequent step S16. Thereby, it is possible to easily deliver the reactive gas to the bottom side of the recess 300.
(f) By the step S14, the first adsorption inhibiting substance adsorbed onto the upper surface and the upper inner surface of the recess 300 in the step S13 may react to desorb the first adsorption inhibiting substance adsorbed onto the upper surface and the upper inner surface of the recess 300. By performing the step S15 after the step S14, the first adsorption inhibiting substance can be adsorbed again onto the upper surface and the upper inner surface of the recess 300. Thereby, it is possible to suppress the adsorption of the reactive gas onto the upper surface and the upper inner surface of the recess 300.
(g) By the step S14, even when the reactive gas is less likely to react with the source gas, by forming the bond between the first adsorption promoting substance and the part of the molecules of the source gas and then replacing the first adsorption promoting substance with a reactant contained in the reactive gas, the source gas can react more easily with the reactive gas. Specifically, the NH₃ is more likely to react with the Ti - I bond or the Ti - H bond rather than with the Ti - Cl bond, and is more likely to be replaced with the Ti - NH bond. As described above, by supplying the HI gas serving as the first adsorption promoter after the source gas is supplied and before the reactive gas is supplied to form the Ti - I bond or the Ti - H bond on the wafer 200, it is possible to promote the replacement with the Ti - N bond by supplying the NH₃ gas. Thereby, it is possible to uniformly form the TiN layer (that is, the second layer) within the recess 300 on the surface of the wafer 200.
(h) The processing mentioned above is performed with the wafers 200 loaded with the interval wider than the predetermined interval. Thereby, it is possible to reduce the effect of the reaction by-products on the wafers 200. In addition, it is also possible to improve the characteristics of the film formed on the wafer 200.

### (4) Modified Examples

The substrate processing according to the present embodiments is not limited to a configuration shown in FIG. 3, and may be modified as shown in the following modified examples.

### <First Modified Example>

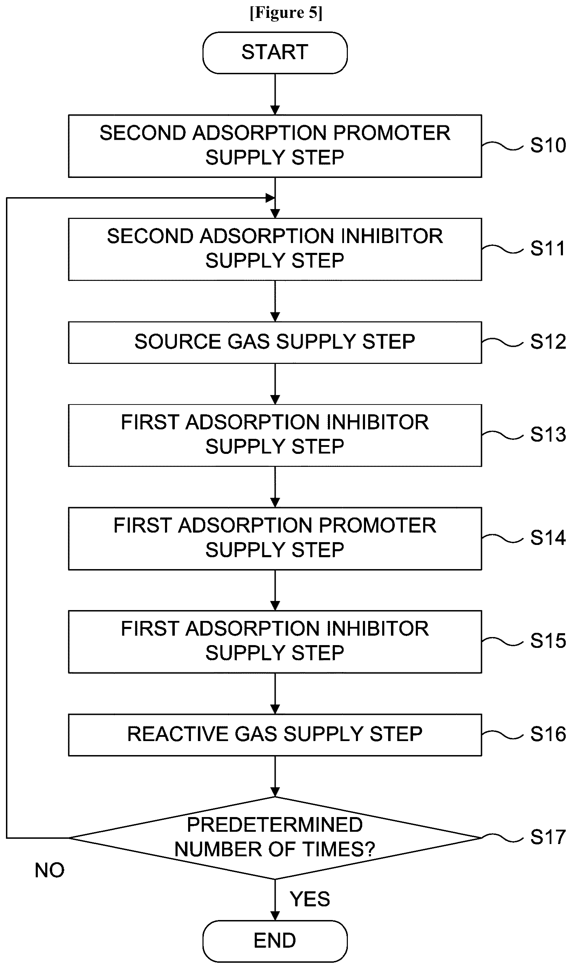

As shown in FIG. 5, the present modified example differs from the substrate processing mentioned above in that a second adsorption promoter is supplied in a step S10 before the step S11. The substrate processing according to the present modified example may be illustrated as follows.

[Second adsorption promoter → P → (Second adsorption inhibitor → P → Source gas → P → First adsorption inhibitor → P → First adsorption promoter → P → First adsorption inhibitor → P → Reactive gas → P) × n] => First element-containing film.

The second adsorption promoter is a gas capable of promoting the adsorption of the source gas supplied in the step S12 onto the wafer 200. As the second adsorption promoter, for example, the reactive gas mentioned above may be used.

### <Second Adsorption Promoter Supply Step, S10>

The valve 324 is opened to supply the second adsorption promoter into the gas supply pipe 320. After a flow rate of the second adsorption promoter is adjusted by the MFC 322, the second adsorption promoter whose flow rate is adjusted is supplied into the process chamber 201 through the gas supply holes 420a of the nozzle 420, and is exhausted through the exhaust pipe 231. In such an operation, the valves 514 to 544 may be opened to supply the inert gas into the process chamber 201 through each of the nozzles 410 to 440.

For example, process conditions when supplying the second adsorption promoter in the present step are as follows:
A supply flow rate of the second adsorption promoter: from 0.1 slm to 30 slm; and
A supply time (time duration) of supplying the second adsorption promoter: from 0.01 second to 30 seconds.

In the present step, the second adsorption promoter is supplied to the wafer 200. Thereby, the second adsorption promoter or a part of molecules of the second adsorption promoter (hereinafter, also referred to as a "second adsorption promoting substance") can be adsorbed onto the upper surface and the upper inner surface of the recess 300 on the surface of the wafer 200. By adsorbing the second adsorption promoting substance onto the surface of the wafer 200 in such a manner, it is possible to promote the adsorption of the source gas in the step S12.

For example, when the NH₃ gas is used as the second adsorption promoter, by supplying the NH₃ gas, a nitrogen (N) - hydrogen (H) termination can be formed on the upper surface and the upper inner surface of the recess 300 on the surface of the wafer 200. Thereby, it is possible to promote an adsorption of the TiClx2.

After the second adsorption promoting substance is adsorbed onto the upper surface and the upper inner surface of the recess 300 on the surface of the wafer 200, the valve 324 is closed to stop a supply of the second adsorption promoter into the process chamber 201. In such an operation, with the APC valve 243 of the exhaust pipe 231 open, the pump 246 vacuum-exhausts the inner atmosphere of the process chamber 201. Thereby, it is possible to remove a residual gas (such as the second adsorption promoter) from above the wafer 200, and it is possible to remove a substance (such as the residual gas and the reaction by-products remaining in the process chamber 201) from the process chamber 201. In such an operation, with the valves 514, 524, 534 and 544 open, the inert gas is continuously supplied into the gas supply pipes 510, 520, 530 and 540. The inert gas acts as the purge gas. Thereby, the process chamber 201 is purged (purge operation).

Subsequently, the steps S11 to S17 of the substrate processing mentioned above are performed. According to the present modified example, it is also possible to obtain substantially the same effects as the embodiments mentioned above. In addition, according to the present modified example, it is possible to further promote the adsorption of the source gas onto the upper surface and the upper inner surface of the recess 300 on the surface of the wafer 200.

### <Second Modified Example to Fourth Modified Example>

In second to fourth modified examples, as illustrated below, a reducing gas is supplied in a manner at least partially simultaneous (in parallel) with the source gas during the supply of the source gas in the step S12 mentioned above.
(Source gas → Source gas + Reducing gas → Reducing gas → P → First adsorption inhibitor → P → First adsorption promoter → P → First adsorption inhibitor → P → Reactive gas → P) × n => First element-containing film
(Source gas → Source gas + Reducing gas → Source gas → P → First adsorption inhibitor → P → First adsorption promoter → P → First adsorption inhibitor → P → Reactive gas → P) × n => First element-containing film
(Source gas → Source gas + Reducing gas → P → First adsorption inhibitor → P → First adsorption promoter → P → First adsorption inhibitor → P → Reactive gas → P) × n => First element-containing film.

In other words, a timing (time duration) in which the source gas and the reducing gas are supplied simultaneously is provided. According to such modified examples, the substrate processing apparatus 10 further includes a reducing gas supplier (which is a reducing gas supply structure or a reducing gas supply system) configured to supply the reducing gas.

### <Second Modified Example>

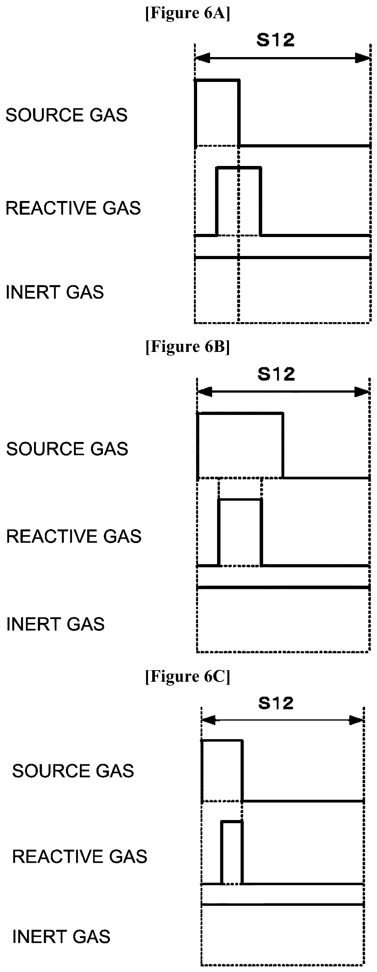

In the present modified example, as shown in FIG. 6A, the valve 314 is opened to supply the source gas. Then, after a predetermined time has elapsed from a start of the supply of the source gas, a supply of the reducing gas is started. Then, after a predetermined time has elapsed from a start of the supply of the reducing gas, the valve 314 is closed to stop the supply of the source gas. Then, after a predetermined time has elapsed from a stop of the supply of the source gas, the supply of the reducing gas is stopped. According to the present modified example, it is also possible to obtain substantially the same effects as the embodiments and the modified example mentioned above. In addition, according to the present modified example, it is possible to further reduce an amount of the reaction by-products generated by the supply of the source gas while suppressing an inhibition of the adsorption of the source gas. Thereby, it is possible to improve a quality of the first element containing film.

### <Third Modified Example>

In the present modified example, as shown in FIG. 6B, the valve 314 is opened to supply the source gas. Then, after a predetermined time has elapsed from the start of the supply of the source gas, the supply of the reducing gas is started. Then, after a predetermined time has elapsed from the start of the supply of the reducing gas, the supply of the reducing gas is stopped. Then, after a predetermined time has elapsed from a stop of the supply of the reducing gas, the valve 314 is closed to stop the supply of the source gas. According to the present modified example, it is also possible to obtain substantially the same effects as the embodiments and the modified examples mentioned above. In addition, according to the present modified example, it is possible to further reduce the amount of the reaction by-products generated by the supply of the source gas while suppressing the inhibition of the adsorption of the source gas. Thereby, it is possible to improve the quality of the first element containing film.

### <Fourth Modified Example>

In the present modified example, as shown in FIG. 6C, the valve 314 is opened to supply the source gas. Then, after a predetermined time has elapsed from the start of the supply of the source gas, the supply of the reducing gas is started. Then, after a predetermined time has elapsed from the start of the supply of the reducing gas, the supply of the source gas and the supply of the reducing gas are simultaneously stopped. According to the present modified example, it is also possible to obtain substantially the same effects as the embodiments and the modified examples mentioned above. In addition, according to the present modified example, it is possible to further reduce the amount of the reaction by-products generated by the supply of the source gas while suppressing the inhibition of the adsorption of the source gas. Thereby, it is possible to improve the quality of the first-element-containing film.

For example, the supply of the source gas and the supply of the reducing gas may be simultaneously started, and simultaneously stopped. Even in such a case, it is also possible to obtain substantially the same effects as the embodiments and the modified examples mentioned above.

As the reducing gas, for example, a gas containing hydrogen (H) and one or more elements among the Group 13 elements and the Group 14 elements of the periodic table may be used. As such a gas, for example, a silane-based gas such as SiH₄ gas, Si₂H₆ gas and Si₃H₈ gas or a borane-based gas such as BH₃ gas and B₂H₆ gas may be used. As the reducing gas, for example, such a hydride may be used.

For example, by supplying the SiH4 gas serving as the reducing gas, it is possible to remove the reaction by-products such as hydrogen chloride (HCl) serving as an adsorption inhibiting gas capable of inhibiting a film formation. In addition, it is possible to remove the reaction by-products such as the HCl adsorbed to a location where the adsorption inhibiting substance is not adsorbed. Thereby, it is possible to form an empty adsorption site (where the source gas can be adsorbed) on the wafer 200. As a result, on the wafer 200, it is possible to provide (or form) the adsorption site where the source gas such as the TiClx2 can be adsorbed. In the present specification, the term "adsorption site" where the source gas can be adsorbed refers to an area (location) on the wafer 200 where the adsorption inhibiting substance is not adsorbed.

The present invention may be summarized as follows: It is possible to improve characteristics of a film formed on a substrate. There is provided a technique that includes: (a) supplying a source gas; (b) supplying a first adsorption promoter; (c) supplying a reactive gas; (d) forming a film on a substrate by sequentially performing (a), (b) and (c) a predetermined number of times; and (e) supplying a first adsorption inhibitor in (d), wherein (e) is performed before (b) or after (b), or (e) is performed before (b) and after (b).

### (5) Other Embodiments of Present Disclosure

The technique of the present disclosure is described in detail by way of the embodiments and the modified examples mentioned above. However, the technique of the present disclosure is not limited thereto. The technique of the present disclosure may be modified in various ways without departing from the scope thereof.

For example, the embodiments and the modified examples mentioned above are described by way of an example in which the second adsorption inhibitor is a gas different from the first adsorption inhibitor. However, the technique of the present disclosure is not limited thereto. For example, the second adsorption inhibitor may be the same gas as the first adsorption inhibitor.

For example, the embodiments and the modified examples mentioned above are described by way of an example in which the first element containing film is formed on the wafer 200 with the recess 300 formed on the surface thereof. However, the technique of the present disclosure is not limited thereto. For example, the technique of the present disclosure may also be applied when the first element containing film such as a barrier metal is formed on the surface of the wafer 200.

It is preferable that the process recipe (that is, a program defining parameters such as process procedures and the process conditions of the substrate processing) used to form the film is prepared individually in accordance with contents of the substrate processing such as a type of the film to be formed, a composition ratio of the film, a quality of the film, a thickness of the film, the process procedures and the process conditions of the substrate processing. That is, it is preferable that a plurality of process recipes are prepared. Then, when starting the substrate processing, it is preferable that an appropriate process recipe is selected among the process recipes in accordance with the contents of the substrate processing. Specifically, it is preferable that the process recipes (program products) are stored (installed) in the memory 121c of the substrate processing apparatus 10 in advance via an electric communication line or the recording medium (that is, the external memory 123) on which the process recipes are recorded. Then, when starting the substrate processing, the CPU 121a of the substrate processing apparatus 10 preferably selects the appropriate process recipe among the process recipes stored in the memory 121c in accordance with the contents of the substrate processing. With such a configuration, various films of different types, different composition ratios, different qualities and different thicknesses can be formed with versatility and with a high reproducibility using a single substrate processing apparatus. In addition, since a burden on an operator such as inputting the process procedures and the process conditions can be reduced, the substrate processing can be started (performed) quickly while avoiding a misoperation of the substrate processing apparatus 10.

For example, the technique of the present disclosure may also be realized by changing an existing process recipe installed in the substrate processing apparatus 10. When changing the existing process recipe to a new process recipe, the process recipe according to the technique of the present disclosure may be installed into the substrate processing apparatus 10 via the electric communication line or the recording medium (that is, the external memory 123) on which the process recipe is recorded, or the existing process recipe itself may be changed to the new process recipe (that is, the process recipe according to the technique of the present disclosure) by operating the input/output device 122 of the substrate processing apparatus 10.

In addition, for example, the technique of the present disclosure may also be used in a structure such as a word line, a barrier film and a control gate of a DRAM and a NAND type flash memory of a three-dimensional structure.

For example, the embodiments and modified examples mentioned above are described by way of an example in which a batch type substrate processing apparatus capable of simultaneously processing a plurality of wafers 200 is used to form the film. However, the technique of the present disclosure is not limited thereto. For example, the technique of the present disclosure may be preferably applied when a single wafer type substrate processing apparatus capable of processing one or several wafers 200 at once is used to form the film. For example, the embodiments and the modified examples mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

For example, the embodiments and the modified examples mentioned above are described by way of an example in which the process sequence mentioned above is performed in the same process chamber of the same substrate processing apparatus (in-situ). However, the technique of the present disclosure is not limited thereto. For example, one step and another step of the process sequence mentioned above may be performed in different process chambers of different substrate processing apparatuses (ex-situ), or each may be performed in a different process chamber of the same substrate processing apparatus.

The process procedures and the process conditions of each process using the substrate processing apparatuses mentioned above may be substantially the same as those of the embodiments or the modified examples mentioned above. Even in such a case, it is possible to obtain substantially the same effects as in the embodiments or the modified examples mentioned above.

For example, the embodiments and the modified examples mentioned above may be appropriately combined. The process procedures and the process conditions of each combination thereof may be substantially the same as those of the embodiments or the modified examples mentioned above.

### [Description of Reference Numerals]

200: Wafer (Substrate)

## Claims

1. A substrate processing method comprising:
(a) supplying a source gas;
(b) supplying a first adsorption promoter;
(c) supplying a reactive gas;
(d) forming a film on a substrate by sequentially performing (a), (b) and (c) a predetermined number of times; and
(e) supplying a first adsorption inhibitor in (d),
wherein (e) is performed before (b) or after (b), or (e) is performed before (b) and after (b).

2. The substrate processing method of claim 1, wherein, in (e), the first adsorption inhibitor is supplied before (b).

3. The substrate processing method of claim 1 and/or 2, wherein a supply amount of the first adsorption inhibitor in (e) is set to be less than a supply amount of the first adsorption promoter in (b).

4. The substrate processing method of any one or more of claims 1 to 3, wherein a supply time of the first adsorption inhibitor in (e) is set to be shorter than a supply time of the first adsorption promoter in (b).

5. The substrate processing method of any one or more of claims 1 to 4, wherein, in (e), the first adsorption inhibitor is supplied after (b).

6. The substrate processing method of claim 5, wherein a supply amount of the first adsorption inhibitor in (e) is set to be less than a supply amount of the first adsorption promoter in (b).

7. The substrate processing method of claim 5 and/or 6, wherein a supply time of the first adsorption inhibitor in (e) is set to be shorter than a supply time of the first adsorption promoter in (b).

8. The substrate processing method of any one or more of claims 1 to 7, wherein the first adsorption inhibitor is supplied before (b) and after (b).

9. The substrate processing method of any one or more of claims 1 to 8, further comprising
(f) supplying a second adsorption inhibitor,
wherein, in (d), (f) is performed before (a).

10. The substrate processing method of claim 9, wherein the second adsorption inhibitor is a gas same as the first adsorption inhibitor, or the second adsorption inhibitor is a gas different from the first adsorption inhibitor.

11. The substrate processing method of any one or more of claims 1 to 10, further comprising
(g) supplying a second adsorption promoter,
wherein (g) is performed before (d) is performed.

12. The substrate processing method of any one or more of claims 1 to 11, wherein the first adsorption inhibitor contains a first halogen or the first adsorption inhibitor contains a second halogen different from the first halogen, and wherein the source gas contains a third halogen different from the second halogen.

13. A method of manufacturing a semiconductor device, comprising
the method of any one or more of claims 1 to 12.

14. A substrate processing apparatus comprising:
a gas supplier configured to supply a source gas, a first adsorption promoter, a reactive gas and a first adsorption inhibitor to a substrate; and
a controller configured to be capable of controlling the gas supplier to perform:
(a) supplying the source gas;
(b) supplying the first adsorption promoter;
(c) supplying the reactive gas;
(d) forming a film on the substrate by sequentially performing (a), (b) and (c) a predetermined number of times; and
(e) supplying the first adsorption inhibitor in (d),
wherein (e) is performed before (b) or after (b), or (e) is performed before (b) and after (b).

15. A program that causes a substrate processing apparatus, by a computer, to perform:
(a) supplying a source gas;
(b) supplying a first adsorption promoter;
(c) supplying a reactive gas;
(d) forming a film on a substrate by sequentially performing (a), (b) and (c) a predetermined number of times; and
(e) supplying a first adsorption inhibitor in (d),
wherein (e) is performed before (b) or after (b), or (e) is performed before (b) and after (b).
